# EUROPEAN PATENT SPECIFICATION

(11) **EP 4 454 515 B1**
(45) Date of publication and mention of the grant of the patent: **28.01.2026**
(21) Application number: 24172872.4
(22) Date of filing: 26.04.2024
(51) Int. Cl.: A47B 97/00, A47B 96/02

(54) **SHELVING POWER TRANSMISSION COMPONENT**
REGALKRAFTÜBERTRAGUNGSKOMPONENTE
COMPOSANT DE TRANSMISSION DE PUISSANCE DE RAYONNAGE

(30) Priority: 26.04.2023 GB 202306152
(43) Date of publication of application: 30.10.2024
(73) Proprietor: Bass, Nigel Anthony, Welwyn Hertfordshire AL6 9BD (GB)
(72) Inventor: Bass, Nigel Anthony, Welwyn Hertfordshire AL6 9BD (GB)
(74) Representative: Dehns

(56) References cited:
- WO-A1-2021/078354
- CN-U- 217 656 717
- US-A1- 2005 011 657
- US-A1- 2012 230 018
- US-A1- 2015 034 574
- US-A1- 2015 289 681

## Description

The present invention relates to a power transmission component for use in a modular shelving system.

Modular shelving systems are used widely throughout the retail trade and particularly throughout supermarkets and are therefore also sometimes known as retail shelving systems. Such systems are generally constructed of at least the following components, which are generally formed of steel: two or more uprights; one or more shelving panels; and shelf-supporting brackets that hook into slots in the uprights and support the shelving panels.

The uprights may be free-standing or wall-mounted and are usually rectangular-section hollow bars of which at least the front face has been provided with a series of slots spaced at fixed intervals along the length of the upright into which the hooks of the shelf-supporting brackets mount. The slots are spaced equidistance apart, commonly with a spacing of 50 mm, although this fixed spacing may differ from one shelving system to another.

The shelving panels of modular shelving systems are often provided with various electrically powered components. Such components may include lighting strips, for example mounted behind a front lip of the shelving panels, and electronic shelf labels, for example mounted on an outward-facing face of the front lip of the shelving panels.

In order to supply power to such components, modular shelving systems may be provided with a low-voltage (often 12V or 24V) power supply track, which extends vertically up a backboard of the shelving system, typically adjacent and parallel to one of the uprights. One or more connector clips electrically and mechanically engage the power supply track, and supply power via cables to the electrically powered components.

US 2015/034574 A1 discloses reinforced shelves for metal shelving units, wherein the shelves support electronic labels and/or other peripherals on their front (facing the public) side, and the labels are connected to electric wiring coming from the rear side of the shelf itself. Further shelving systems are disclosed in US2015289681 A1 and US2012230018 A1. Connectors with telescopic shields are disclosed in WO2021078354 A1, US2005011657 A1 and CN217656717 U.

One advantage of a modular shelving system is that shelves of different sizes can be used with the same uprights. However, this means that it is necessary to design the electrically powered components with sufficient length of cable for the connector clips to reach the power supply track with any size of shelf. This design results in an excess of cable in many cases, which is commonly bundled up and tucked or affixed underneath the shelving panels.

This existing design is undesirable as the trailing wires can be unsightly, or obtrusive if they fall down and hang below the shelving systems. Furthermore, the wires can be damaged or cut if they are caught between the shelving panels and the shelf-supporting brackets, potentially electrifying the shelf as well as incurring monetary and time costs to replace the wire. It has to be remembered that whilst the system is 12-24v there is still amperage to be considered. I have come across situations in old buildings where there are not protect consumer boards.

Additionally, the shelving clips can be detached from the power supply track, either accidentally or by malicious customers, which results in an undesired loss of power. Also, if it is desired to move the shelving panels, then each of the connector clips must be detached and re-attached manually in order to move the shelving panes.

At least the preferred embodiments of the present invention seek to address the above problems.

Viewed from a first aspect, the present invention provides a shelving system, comprising: a power distribution track; a shelf comprising a front edge; a power-consuming component at a front edge of the shelf; and a power transmission component for transmission of power from the power distribution track to the power-consuming component. The power transmission component comprises an extendible power cable; a first power head connected to a first end of the power cable and configured to engage the power distribution track of the shelving system; a second power head connected to a second, opposite end of the power cable and configured to engage the power-consuming component of the shelving system; and a telescopic shield connected to the first power head and the second power head, the telescopic shield being configured to at least partially surround the power cable. The power transmission component electrically connects the power-consuming component to the power distribution track. The power transmission component and the shelving system are configured for the power transmission component to be mounted to an underside of the shelf of the shelving system such that, when the shelf is installed, the first power head is brought into contact with the power distribution track. The shelf is configured to be mounted by inserting a connector of the shelf to a slot, and subsequently rotating the shelf into a horizontal configuration. The shelving system is configured such that rotation of the shelf brings the first power head of the power transmission component into electrical connection with the power distribution track of the shelving system.

By virtue of this design, power can be effectively transmitted from a power distribution track at the back of the shelving system to a power-consuming component at the front of the shelving system. The use of an extendible cable and shield allows the power transmission component to be used with shelves of different sizes, whilst protecting the power cable from damage and preventing it from sagging in an unsightly or inconvenient manner.

The first power head may comprise a fastener, such as a magnet, configured to maintain electrical connection between the first power head and the power distribution track.

The power cable may be configured to extend in length and to resiliently retract. The power cable may comprise a spiral cable. The telescopic shield may fully surround the power cable. The telescopic shield may act as a protective shield for the power cable.

The telescopic shield may be made of metal. The telescopic shield may be telescopic. The telescopic shield may comprise a plurality of nested tubes. The nested tubes may be configured to slide axially with respect to one another, e.g. so as to extend a length of the protective shield. The nested tubes may comprise respective lips at their ends, such that they cannot slide completely past one another, thereby preventing the cord from becoming exposed.

The telescopic shield may be at least partially resistant to retracting, e.g., due to friction between nested tubes. The resistance to retracting may be greater than a contracting force applied by the power cord. Alternatively, or additionally, the telescopic shield may comprise an axial-position locking mechanism, for example such that the length of the telescopic shield is lockable at one or more lengths. The axial-position locking mechanism may comprise a button clip or a twist-lock design.

The power-consuming component may comprise a lighting component, an electronic shelf label, or a camera. In other examples, the power-consuming component may a mobile phone charging station, a weighing scale, a fridge, a hot plate, a fan, a smell machine, a display or a television.

The power-consuming component may be a low-voltage component configured to use a voltage below 50V, such as 12V, 24V or 48V. Thus, the power-distribution track may be configured to supply low-voltage electricity, i.e., below 50V, such as 12V, 24V or 48V.

The first power head may be mechanically connected to a first axial end of the telescopic shield. The second power head may be mechanically connected to a second axial end of the telescopic shield. The power cable may not be exposed outside of the telescopic shield between the first power head and the second power head. The telescopic shield may be at least partially resistant to retracting such that the telescopic shield holds its length, once set.

The shelf may comprise a brace on an underside thereof and extending in a width-wise direction of the shelf, wherein the brace comprises a through hole in a depth-wise direction of the shelf, and wherein the power transmission component extends through the through hole.

The shelf may be configured such that power transmission component cannot be non-destructively removed from the shelf when the shelf is mounted within the shelving system.

The installation of the shelf may comprise inserting a connector of the shelf into a slot of the shelving system, and subsequently rotating the shelf into a horizontal configuration.

The shelving system may be a free-standing system or may comprise a base configured to rest on the floor. The shelving system may comprise two or more uprights. The base unit may be configured to support the uprights substantially vertically, and/or the uprights may be configured to be attached to a wall.

The shelving system, and particularly the uprights of the shelving system, may have a height between 1.4 and 2.1m. The shelf may have a depth (i.e., from front to back) of between 250 mm and 750 mm, and may have a width (i.e., from side to side) of between 600 mm and 1250 mm. Optionally, the shelf may be one of a plurality of shelves. The shelving system may be configured to receive shelves of different depths and/or widths.

The shelving system, and particularly the uprights, may comprises a plurality of openings, such as slots, for supporting the shelf. Particularly, the slots may be configured to receive one or more shelf-supporting bracket. The shelf-supporting brackets may each comprise one or more fasteners, such as hooks, which may be configured to engage the shelving system, for example via the openings.

The shelf may comprise a shelf surface, which may be substantially horizontal in use, for example for holding products or the like. The shelf may comprise a shelf front-edge, which is inclined relative to the horizontal, e.g., at between 45° and 90°, e.g., around 80°.

In one embodiment, the power-consuming component may comprise an electronic shelf label or a camera, and the shelf front-edge may be configured to support the electronic shelf label or the camera.

In another embodiment, the power-consuming component may comprise a light, such as a lighting strip, which may be mounted under the shelf surface and/or behind the shelf front-edge.

The shelving system may comprise a vertical backboard, which may be supported between the uprights. The power supply track 12 may extend up the vertical backboard. The power supply track may comprise parallel live and neutral power rails. The power supply track 12 may be configured to connect to a mains power supply, for example via an electronic driver. The shelving system may include an electronic driver, for example within a base of the shelving system.

Viewed from a second aspect, the present invention provides a method, comprising: mounting a power transmission component to an underside of a shelf; wherein the power transmission component is for transmission of power from a power distribution track of a shelving system to a power-consuming component at a front edge of a shelf of the shelving system, the power transmission component comprising: an extendible power cable; a first power head connected to a first end of the power cable and configured to engage the power distribution track of the shelving system; a second power head connected to a second, opposite end of the power cable and configured to engage the power-consuming component of the shelving system; and a telescopic shield connected to the first power head and the second power head, the telescopic shield being configured to at least partially surround the power cable; installing the shelf within a shelving system such that the first power head of the power transmission component is electrically connected to a power distribution track of the shelving system; mounting a power-consuming component at a front edge of the shelf; and electrically connecting the power-consuming component to the second power head of the power transmission component, wherein the shelf is mounted to the shelving system by inserting a connector of the shelf to a slot of the shelving system, and subsequently rotating the shelf into a horizontal configuration, and wherein the rotation of the shelf brings the first power head of the power transmission component into electrical connection with the power distribution track of the shelving system.

Certain preferred embodiments of the invention will now be described in greater detail, by way of example only, and with reference to the accompanying drawings, in which:
Figure 1 shows a modular shelving system;
Figure 2 shows a power transmission component for use with the modular shelving system;
Figure 3 shows details of a first power head of the power transmission component;
Figure 4 shows an underside of a shelf panel of the modular shelving system including the power transmission component and a lighting component;
Figure 5 shows the shelving panel partially engaged with a shelf-supporting bracket of the modular shelving system;
Figure 6 shows an electronic shelf label track for a shelving panel of the modular shelving system; and
Figure 7 shows a shelving panel having an opening for receiving a camera.

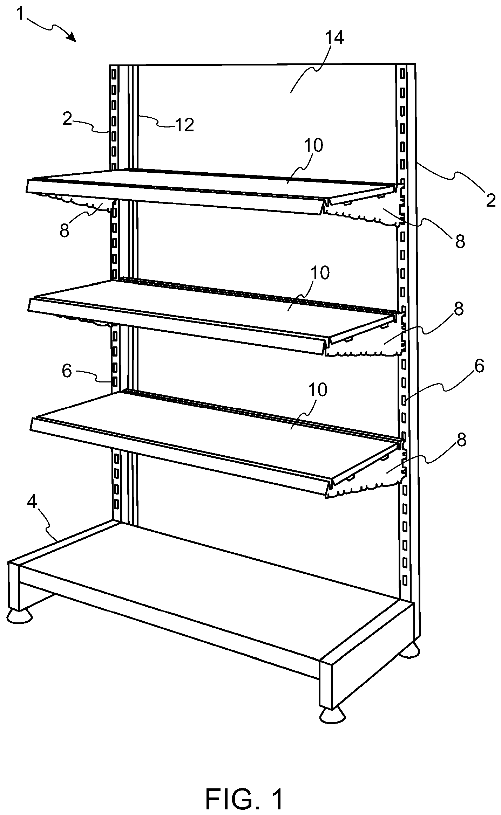

Figure 1 shows a modular shelving system 1.

The modular shelving system 1 comprises a pair of uprights 2. The illustrated modular shelving system 1 is a free-standing system, sometimes known as gondola shelving, and comprises a base unit 4 configured to rest on the floor and to support the uprights 2 substantially vertically.

The uprights 2 take the form of rectangular-section hollow bars, commonly formed from steel. The uprights 2 are usually of a height between 1.4 and 2.1m. The uprights 2 each comprises a plurality of slots 6, which are equally spaced vertically along the length of the respective upright 2, for example with a spacing of 50mm. The uprights 2 may be provided with slots on one side, or both sides, i.e., such that shelves may be provided on one or both sides of the modular shelving system 1.

The slots 6 are configured to receive shelf-supporting brackets 8. The shelf-supporting brackets 8 each comprise one or more hooks (two in the illustrated example) that engage respective slots 6 of the uprights 2. This engagement supports the supporting brackets 8 against vertically downward loading, and largely prevents horizontal movement, in either the width-wise or depth-wise directions of the modular shelving system 1, of the shelf-supporting brackets 8.

The modular shelving system 1 further comprises a plurality of shelving panels 10, which are each supported by two of the shelf-supporting brackets 8. The shelving panels 10 provide a shelf surface, which is substantially horizontal for holding products or the like, and a shelf front-edge, which is inclined relative to the horizontal, e.g., at around 80°, for supporting shelf labels or the like. Often shelving panels 10 are available in a variety of depths (i.e., from front to back), typically between 250 mm and 750 mm, and a variety of widths (i.e., from side to side), typically between 500 mm and 1250 mm.

The shelving panels 10 are configured to engage the shelf-supporting brackets 8 in a manner such that they cannot slide horizontally, so as to prevent the shelving panes 10 from moving once the module shelving system 1 is employed. This may be achieved in the depth-wise direction by providing notches in the shelf-supporting brackets 8 that engage with corresponding lips or other projections on the undersides of the shelving panels 10. This may be achieved in the width-wise direction by providing lips that overhand the lateral edges of the shelf-supporting brackets 8, or grooves to receive the shelf-supporting brackets 8.

In the illustrated modular shelving system 1, the shelving panels 10 are installed by bringing them into contact with the rear end of the shelf-supporting brackets 8 at an angle to the horizontal. Then, the shelving panels 10 are rotated about their rear end into a horizontal position, such that they rest atop the shelf-supporting brackets 8. In this position, they are locked against horizontal movement.

The modular shelving system 1 further comprises a power supply track 12. The power supply track 12 will typically be connected to a mains power supply, for example via an electronic driver (not shown). The power supply track 12 extends up a vertical backboard 14 of the modular shelving system 1, supported between the uprights 2. The illustrated power supply track 12 comprises parallel live and neutral power rails. The power supply track 12 is configured to supply low-voltage electricity, for example at 12V or 24V, to power components of the modular shelving system 1.

The power supply track 12 may be used for supplying power to power-consuming components, including lighting strips and electronic shelf labels, which are often located adjacent the front lip of the shelving panels 10. Therefore, a power transmission component 20 is required.

The power transmission component 20 may be used for supplying power for any of the following uses: charging mobile phones or other portable electronic devices, LED shelf lighting, cameras, weighing scales, fridges, hot plates, electronic POS labels, fans, smell machines, POS displays, TV screens, etc.

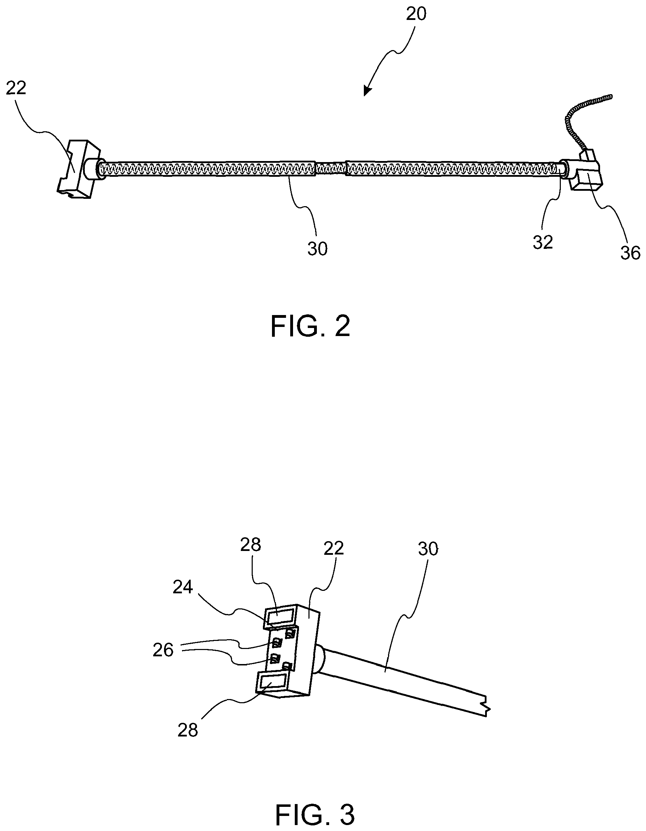

Figure 2 illustrates a power transmission component 20, and Figure 3 illustrates details of a first power head of the power transmission component 20.

The power transmission component 20 comprises the first power head 22 configured to engage the power supply track 12 of the modular shelving system 1. To achieve this, the first power head 22 comprises a groove 24 sized to receive and engage with the power supply track 12, and a plurality of electrical contacts 26 configured to engage with respective live and neutral rails of the power supply track 12. In the illustrated embodiment, the first power head 22 comprises two pairs of electrical contacts 26 configured to engage with different designs of power supply track 12.

It will be appreciated that the first power head 22 may take different forms, depending on the specific design of the power supply track 12 of the modular shelving unit.

The first power head 22 also comprises a retainer, configured to hold the electrical contacts 26 of the power head 22 against the power supply track 12. In the illustrated embodiment, this takes the form of one or more magnets 28 configured to engage with the backboard of the modular shelving unit 1, which is normally formed of magnetic steel. Of course, other designs of retainer may be used, such as a mechanical clip or the like.

The first power head 22 is electrically connected to an extendible power cord (not shown). The extendible power cord, in one example, takes the form of a spiral cord. This allows the length of the cord to be extended easily, such that a single power transmission component 20 can be used for shelving panels 10 of different depths. This design advantageously resiliently retracts, such that excess wire is kept coiled.

The first power head 22 is also mechanically connected to a first axial end of a protective shield 30. The protective shield 30 surrounds the power cord. The protective shield is also extendible, such that the power transmission component 20 can be used with shelving panels 10 of different depths.

The protective shield 30 protects the power cord from damage, for example by becoming trapped between the shelf-supporting bracket 8 and the shelving panel 10 during assembly. Additionally, the protective shield 30 prevents the cable from sagging, which enhances visual appeal and reduces the risk of the cord becoming caught when the modular shelving system 1 is in use, for example by a person's hand or by part of a product as it moves underneath the shelving panel 10.

The protective shield 30 takes the form of a telescopic tube in the illustrated embodiment, i.e., comprising a plurality of nested tubes that can slide axially with respect to one another so as to extend the length of the protective shield 30. The nested tubes comprise respective lips at their ends, such that they cannot slide completely past one another, thereby preventing the cord from becoming exposed.

The protective shield 30 may be at least partially resistant to retracting, e.g., due to friction between the nested tubes, and this resistance should be greater than a contracting force applied by the extendible power cord, such that the protective shield 30 holds its length, once set. Alternatively, or additionally, protective shield 30 may comprise an axial-position locking mechanism such that the length of the protective shield 30 is lockable at one or more lengths, for example using a button clip or a twist-lock design.

At a second axial end of the protective shield 30, opposite the first axial end, the power transmission component 20 comprises a second power head 32, which is electrically connected to the power cord. In the illustrated example, the second power head 32 is mounted inside of the protective shield 30.

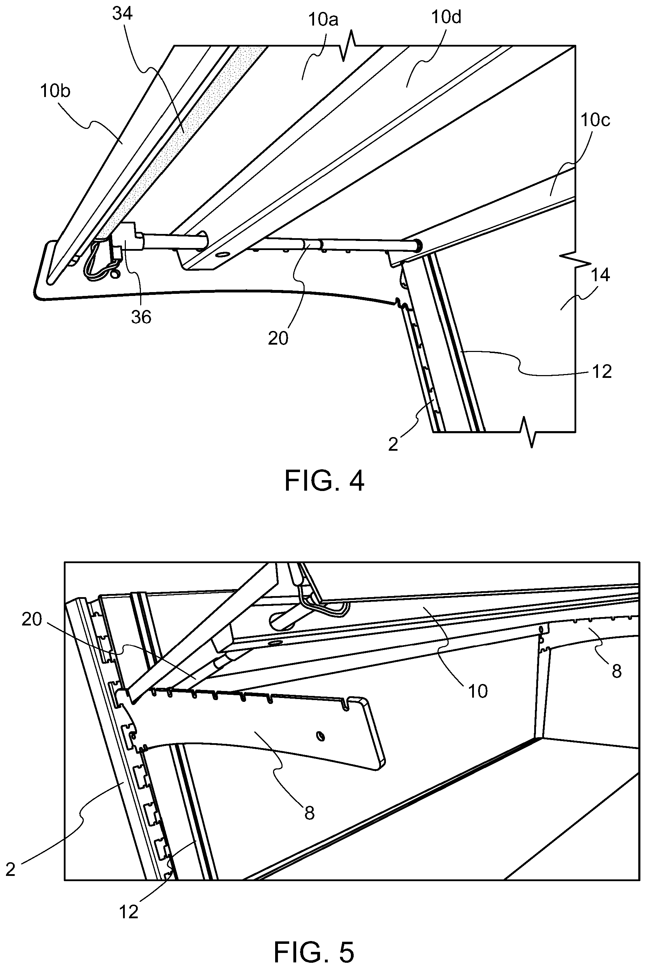

Figure 4 shows the power transmission component 20 in use to supply power to a lighting component.

As discussed above, the modular shelving system 1 comprises a plurality of shelving panels 10, the underside of one of which is shown in Figure 4. As can be seen, the shelving panel 10 comprises main panel 10a, which is substantially horizontal, in use, for supporting products.

A front lip 10b and a rear lip 10b of the shelving panel 10 each extend generally downward from the main panel 10a at a front and a rear of the main panel 10a, respectively. The front lip 10b is angled at approximately 80° with respect to horizontal and permits shelf labels or the like to be connected to the shelving panel 10.

Additionally, a reinforcement bar 10d extends in a width-wise direction along the underside of the main panel 10a. The reinforcement bar 10d provides bending reinforcement to the main panel 10a.

The lighting component comprises a strip light 34 is connected to the underside of the main panel 10a, behind and proximate the front lip 10b, so as to illuminate products on a shelf below the illustrated shelving panel 10. Often such strip light 34 are connected to the shelving panel 10 by magnets, although other mounting techniques are possible. As discussed above, the light strip 34 is a low-voltage component.

The lighting component further comprises a power connector 36, connected to the strip light 34 by a short cable, e.g., less than 10 cm. The power connector 36 is configured to electrically engage with the second power head 32 of the power transmission component 20. The power connector 36 also mechanically engages with the protective shield of the power transmission component 20 using a friction-fit connection.

Through-holes are provided through each of the rear lip 10b and the reinforcement bar 10d, through which passes the power cable of power transmission component 20, inside the protective shield 30. The through-holes extend in a depth-wise direction of the shelving panel 10. The through-holes act to hold the transmission component 20 close to the underside of the shelving panel 10, keeping it secure and reducing the risk of it becoming detached.

In use, the first power head 22 is located behind the rear lip 10c of the shelving panel 10. The thickness of the first power head 22 is such that the rear lip 10c holds it against the power supply track 12, thereby preventing disconnection of the first power head 22 from the power supply track 12 when the shelving panel 10 is in place.

Figure 5 shows a shelving panel 10 of the modular shelving system 1 being connected.

As described above, a shelving panel 10 is installed by bringing it into contact with the rear end of the shelf-supporting brackets 8 at an angle to the horizontal, as shown in Figure 5. Then, the shelving panel 10 is rotated about its rear end into a horizontal position, such that it will rest atop the shelf-supporting brackets 8. The shelves can also slope to any desired angle, e.g. between 5° and 30°, not just horizontally.

In the position shown in Figure 5, the angle of the shelving panel 10 causes the first power head 22 to be disengaged from the power supply track 12. Then, as the shelving panel 10 is rotated about its rear end, the first power head 22 is brought into contact with the power supply track 12, thereby supplying power to the lighting component. This effect is achieved by virtue of shape of the first power head 22, and the positions of the through-holes in the shelving panel 10.

By virtue of this configuration, the power supply component 20 is automatically connected and disconnected to the power supply track when the shelving panel 10 is connected or disconnected from the system 2. This simplifies both the initial installation of the modular shelving system 1, as well as subsequent rearrangement of the modular shelving system 1. It also reduces the risk of errors, for example of forgetting to connect a clip to the power supply track 12, or incorrectly connecting such a clip. It also reduces the risk of the power transmission component 20 becoming disconnected accidentally from the power supply track 12.

A main feature of the design is that all the components needed to bring power to the front of shelf are self-contained within the shelf.

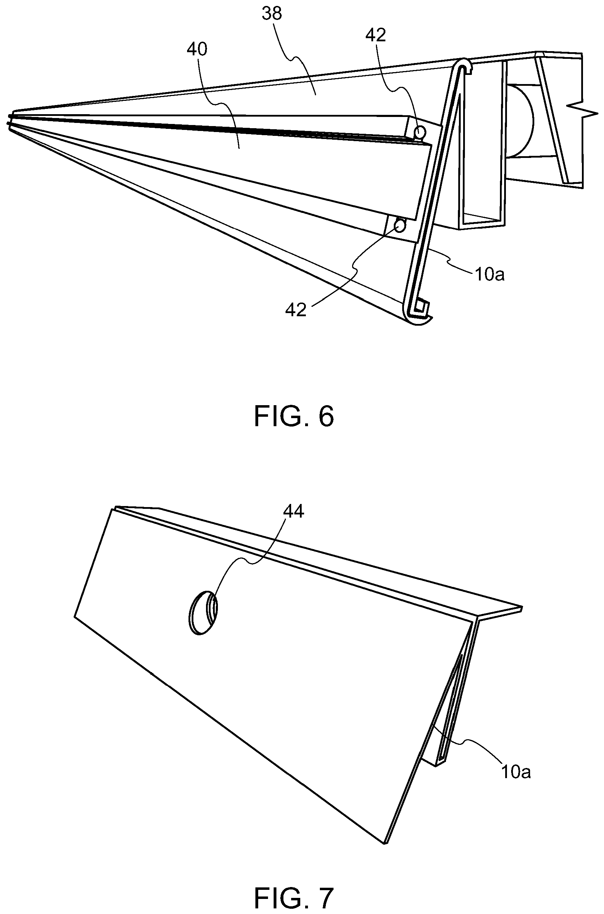

In addition to the lighting component, the modular shelving unit 1 may be configured to receive one or more electronic shelf labels (ESLs). Figure 6 shows an ESL strip connected to the front lip 10a of a shelving panel 10.

ESLs are low-voltage components, which are mounted at the front edge of the shelves to display product information, such as prices, using LCD displays or the like. ESLs are typically network-connected, often using wireless technology, such that that can be automatically updated whenever product information is changed under the control of a central server.

The ESL strip 38 is connected to the front lip 10a of the shelving panel 10 using resilient lips along its upper and lower edge.

The ESL strip 38 comprises a track 40 for mechanically retaining a plurality of ESLs along the length of the shelving panel 10. The track 40 comprises live and neutral power rails 42 for supplying low-voltage electricity to the ESLs. The rails 42 may be electrically connected to the power supply component 20 using the same power connector 36 are the lighting component, or via its own power connector if the lighting component is not present.

In another embodiment, the modular shelving unit 1 may be configured to receive one or more camera. Figure 7 shows a shelving panel 10 modified to receive a camera (not shown).

As can be seen, a hole 44 is formed in the front lip 10a through which a lens of the camera can be exposed. The hole should be small enough not to catch a child's finger in it. In many instances a plastic shelf label profile is added to the front lip 10a of the shelving panel 10. Therefore, the hole would not be seen in instances where a camera is not being used.

The camera may be able to identify a stock situation of a shelf opposite the shelving system 1, for example does the shelf need refilling. In some instances, the camera could be used for a cashierless store in order to track customers picking up items from the shelf opposite.

In some embodiments, the camera may be used for facial recognition.

The camera would require power, which can be supplied using the power transmission component 20 described above.

Whilst the modular shelving system 1 is illustrated as a free-standing system 1, the invention is applicable also to wall-mounted modular shelving systems, where the uprights 2 are mounted directly to a vertical wall.

Furthermore, whilst the illustrated example comprises shelves comprising separate shelving panels 10 and shelf-supporting brackets 8, the invention is applicable also to modular shelving systems 1 where the shelving panels 10 and shelf-supporting brackets 8 are integrally connected, i.e., forming shelves that can be directly connected to the uprights 2.

## Claims

1. A shelving system (1), comprising:
a power distribution track (12);
a shelf (10) comprising a front edge;
a power-consuming component (34) at a front edge of the shelf; and
a power transmission component (20) for transmission of power from the power distribution track to the power-consuming component, the power transmission component comprising:
an extendible power cable;
a first power head (22) connected to a first end of the power cable and configured to engage the power distribution track of the shelving system;
a second power head (32) connected to a second, opposite end of the power cable and configured to engage the power-consuming component of the shelving system; and
a telescopic shield (30) connected to the first power head and the second power head, the telescopic shield being configured to at least partially surround the power cable,
wherein the power transmission component electrically connects the power-consuming component to the power distribution track,
wherein the power transmission component and the shelving system are configured for the power transmission component to be mounted to an underside of the shelf of the shelving system such that, when the shelf is installed, the first power head is brought into contact with the power distribution track,
wherein the shelf is configured to be mounted by inserting a connector of the shelf to a slot, and subsequently rotating the shelf into a horizontal configuration, and
wherein the shelving system is configured such that rotation of the shelf brings the first power head of the power transmission component into electrical connection with the power distribution track of the shelving system.

2. A shelving system according to claim 1, wherein the first power head comprises a magnet configured to maintain electrical connection between the first power head and the power distribution track.

3. A shelving system according to any preceding claim, wherein the power cable comprises a spiral cable.

4. A shelving system according to any preceding claim, wherein the power-consuming component comprises a lighting component, an electronic shelf label, or a camera.

5. A shelving system according to any preceding claim, wherein the power-consuming component is a low-voltage component configured to use a voltage below 50V.

6. A shelving system according to any preceding claim, wherein the first power head is mechanically connected to a first axial end of the telescopic shield, and wherein the second power head is mechanically connected to a second axial end of the telescopic shield.

7. A shelving system according to claim 6, wherein the power cable is not exposed outside of the telescopic shield between the first power head and the second power head.

8. A shelving system according to any preceding claim, wherein the telescopic shield is at least partially resistant to retracting such that the telescopic shield holds its length, once set.

9. A shelving system according to any preceding claim, wherein the shelf comprises a brace on an underside thereof and extending in a width-wise direction of the shelf, wherein the brace comprises a through hole in a depth-wise direction of the shelf, and wherein the power transmission component extends through the through hole.

10. A shelving system according to any preceding claim, wherein the shelf is configured such that power transmission component cannot be non-destructively removed from the shelf when the shelf is mounted within the shelving system.

11. A method, comprising:
mounting a power transmission component to an underside of a shelf;
wherein the power transmission component is for transmission of power from a power distribution track of a shelving system to a power-consuming component at a front edge of a shelf of the shelving system, the power transmission component comprising:
an extendible power cable;
a first power head connected to a first end of the power cable and configured to engage the power distribution track of the shelving system;
a second power head connected to a second, opposite end of the power cable and configured to engage the power-consuming component of the shelving system; and
a telescopic shield connected to the first power head and the second power head, the telescopic shield being configured to at least partially surround the power cable;
installing the shelf within a shelving system such that the first power head of the power transmission component is electrically connected to a power distribution track of the shelving system;
mounting a power-consuming component at a front edge of the shelf; and
electrically connecting the power-consuming component to the second power head of the power transmission component,
wherein the shelf is mounted to the shelving system by inserting a connector of the shelf to a slot of the shelving system, and subsequently rotating the shelf into a horizontal configuration, and
wherein the rotation of the shelf brings the first power head of the power transmission component into electrical connection with the power distribution track of the shelving system.

## Patentansprüche

1. Regalsystem (1), umfassend:
eine Leistungsverteilungsschiene (12);
ein Regal (10), das eine Vorderkante umfasst;
eine Leistungsverbrauchskomponente (34) an einer Vorderkante des Regals; und
eine Leistungsübertragungskomponente (20) zur Übertragung von Leistung von der Leistungsverteilungsschiene an die Leistungsverbrauchskomponente, wobei die Leistungsübertragungskomponente umfasst:
ein streckbares Leistungskabel;
einen ersten Leistungskopf (22), der mit einem ersten Ende des Leistungskabels verbunden ist und konfiguriert ist, um in die Leistungsverteilungsschiene des Regalsystems einzugreifen;
einen zweiten Leistungskopf (32), der mit einem gegenüberliegenden zweiten Ende des Leistungskabels verbunden ist und konfiguriert ist, um in die Leistungsverbrauchskomponente des Regalsystems einzugreifen; und
eine ausziehbare Stulpe (30), die mit dem ersten Leistungskopf und dem zweiten Leistungskopf verbunden ist, wobei die ausziehbare Stulpe konfiguriert ist, um das Leistungskabel zumindest teilweise zu umgeben,
wobei die Leistungsübertragungskomponente die Leistungsverbrauchskomponente elektrisch mit der Leistungsverteilungsschiene verbindet,
wobei die Leistungsübertragungskomponente und das Regalsystem so konfiguriert sind, dass die Leistungsübertragungskomponente an einer Unterseite des Regals des Regalsystems derart montiert wird, dass der erste Leistungskopf mit der Leistungsverteilungsschiene in Kontakt gebracht wird, wenn das Regal installiert ist,
wobei das Regal so konfiguriert ist, dass es montiert wird, indem ein Verbindungsstück des Regals in einen Schlitz eingeführt wird und das Regal anschließend in eine horizontale Konfiguration gedreht wird, und
wobei das Regalsystem derart konfiguriert ist, dass eine Drehung des Regals den ersten Leistungskopf der Leistungsübertragungskomponente mit der Leistungsverteilungsschiene des Regalsystems in elektrischen Kontakt bringt.

2. Regalsystem nach Anspruch 1, wobei der erste Leistungskopf einen Magneten umfasst, der konfiguriert ist, um eine elektrische Verbindung zwischen dem ersten Leistungskopf und der Leistungsverteilungsschiene aufrechtzuerhalten.

3. Regalsystem nach einem vorstehenden Anspruch, wobei das Leistungskabel ein Spiralkabel umfasst.

4. Regalsystem nach einem vorstehenden Anspruch, wobei die Leistungsverbrauchskomponente eine Beleuchtungskomponente, ein elektronisches Regaletikett oder eine Kamera umfasst.

5. Regalsystem nach einem vorstehenden Anspruch, wobei die Leistungsverbrauchskomponente eine Niederspannungskomponente ist, die konfiguriert ist, um eine Spannung unter 50V zu verwenden.

6. Regalsystem nach einem vorstehenden Anspruch, wobei der erste Leistungskopf mechanisch mit einem ersten axialen Ende der ausziehbaren Stulpe verbunden ist, und wobei der zweite Leistungskopf mechanisch mit einem zweiten axialen Ende der ausziehbaren Stulpe verbunden ist.

7. Regalsystem nach Anspruch 6, wobei das Leistungskabel zwischen dem ersten Leistungskopf und dem zweiten Leistungskopf nicht außerhalb der ausziehbaren Stulpe freiliegt.

8. Regalsystem nach einem vorstehenden Anspruch, wobei die ausziehbare Stulpe zumindest teilweise einem Zurückziehen derart widersteht, dass die ausziehbare Stulpe ihre Länge beibehält, wenn diese einmal festgelegt ist.

9. Regalsystem nach einem vorstehenden Anspruch, wobei das Regal eine Klammer an einer Unterseite davon umfasst, die sich in einer Breitenrichtung des Regals erstreckt, wobei die Klammer eine Durchgangsöffnung in einer Tiefenrichtung des Regals umfasst, und wobei die Leistungsübertragungskomponente sich durch die Durchgangsöffnung erstreckt.

10. Regalsystem nach einem vorstehenden Anspruch, wobei das Regal derart konfiguriert ist, dass die Leistungsübertragungskomponente nicht zerstörungsfrei vom Regal entfernt werden kann, wenn das Regal innerhalb des Regalsystems montiert ist.

11. Verfahren, umfassend:
Montieren einer Leistungsübertragungskomponente an einer Unterseite eines Regals;
wobei die Leistungsübertragungskomponente zur Übertragung von Leistung von einer Leistungsverteilungsschiene eines Regalsystems an eine Leistungsverbrauchskomponente an einer Vorderkante eines Regals des Regalsystems dient, wobei die Leistungsübertragungskomponente umfasst:
ein streckbares Leistungskabel;
einen ersten Leistungskopf, der mit einem ersten Ende des Leistungskabels verbunden ist und konfiguriert ist, um in die Leistungsverteilungsschiene des Regalsystems einzugreifen;
einen zweiten Leistungskopf, der mit einem gegenüberliegenden zweiten Ende des Leistungskabels verbunden ist und konfiguriert ist, um in die Leistungsverbrauchskomponente des Regalsystems einzugreifen;
eine ausziehbare Stulpe, die mit dem ersten Leistungskopf und dem zweiten Leistungskopf verbunden ist, wobei die ausziehbare Stulpe konfiguriert ist, um das Leistungskabel zumindest teilweise zu umgeben;
Installieren des Regals innerhalb eines Regalsystems derart, dass der erste Leistungskopf der Leistungsübertragungskomponente mit einer Leistungsverteilungsschiene des Regalsystems elektrisch verbunden ist;
Montieren einer Leistungsverbrauchskomponente an einer Vorderkante des Regals; und
elektrisches Verbinden der Leistungsverbrauchskomponente mit dem zweiten Leistungskopf der Leistungsübertragungskomponente,
wobei das Regal am Regalsystem montiert wird, indem ein Verbindungsstück des Regals in einen Schlitz des Regalsystems eingeführt wird und das Regal anschließend in eine horizontale Konfiguration gedreht wird, und
wobei die Drehung des Regals den ersten Leistungskopf der Leistungsübertragungskomponente mit der Leistungsverteilungsschiene des Regalsystems in elektrischen Kontakt bringt.

## Revendications

1. Système de rayonnage (1) comprenant :
un chemin de distribution de puissance (12) ;
une étagère (10) comprenant un bord avant ;
un composant de consommation de puissance (34) au niveau d'un bord avant de l'étagère ; et
un composant de transmission de puissance (20) pour transmettre de la puissance à partir du chemin de distribution de puissance vers le composant de consommation de puissance, le composant de transmission de puissance comprenant :
un câble de puissance extensible ;
une première tête de puissance (22) connectée à une première extrémité du câble de puissance et configurée pour mettre en prise le chemin de distribution de puissance du système de rayonnage ;
une seconde tête de puissance (32) connectée à une seconde extrémité, opposée, du câble de puissance et configurée pour mettre en prise le composant de consommation de puissance du système de rayonnage ; et
une protection télescopique (30) connectée à la première tête de puissance et à la seconde tête de puissance, la protection télescopique étant configurée pour au moins partiellement entourer le câble de puissance,
dans lequel le composant de transmission de puissance connecte le composant de consommation de puissance au chemin de distribution de puissance,
dans lequel le composant de transmission de puissance et le système de rayonnage sont configurés pour que le composant de transmission de puissance soit monté sur un côté inférieur de l'étagère du système de rayonnage de sorte que, lorsque l'étagère est installée, la première tête de puissance est mise en contact avec le chemin de distribution de puissance,
dans lequel l'étagère est configurée pour être montée en insérant un connecteur de l'étagère dans une fente, et en faisant tourner ultérieurement l'étagère dans une configuration horizontale, et
dans lequel le système de rayonnage est configuré de sorte que la rotation de l'étagère amène la première tête de puissance du composant de transmission de puissance en connexion avec le chemin de distribution de puissance du système de rayonnage.

2. Système de rayonnage selon la revendication 1, dans lequel la première tête de puissance comprend un aimant configuré pour maintenir une connexion électrique entre la première tête de puissance et le chemin de distribution de puissance.

3. Système de rayonnage selon une quelconque revendication précédente, dans lequel le câble de puissance comprend un câble spiralé.

4. Système de rayonnage selon une quelconque revendication précédente, dans lequel le composant de consommation de puissance comprend un composant d'éclairage, une étiquette d'étagère électronique, ou une caméra.

5. Système de rayonnage selon une quelconque revendication précédente, dans lequel le composant de consommation de puissance est un composant basse tension configuré pour utiliser une tension inférieure à 50 V.

6. Système de rayonnage selon une quelconque revendication précédente, dans lequel la première tête de puissance est mécaniquement connectée à une première extrémité axiale de la protection télescopique, et dans lequel la seconde tête de puissance est mécaniquement connectée à une seconde extrémité axiale de la protection télescopique.

7. Système de rayonnage selon la revendication 6, dans lequel le câble de puissance n'est pas exposé à l'extérieur de la protection télescopique entre la première tête de puissance et la seconde tête de puissance.

8. Système de rayonnage selon une quelconque revendication précédente, dans lequel la protection télescopique est au moins partiellement résistante à la rétractation de sorte que la protection télescopique maintienne sa longueur, une fois réglée.

9. Système de rayonnage selon une quelconque revendication précédente, dans lequel l'étagère comprend une console sur un côté inférieur de celle-ci et s'étendant dans un sens de la largeur de l'étagère, dans lequel la console comprend un trou traversant dans un sens de la profondeur de l'étagère, et dans lequel le composant de transmission de puissance s'étend à travers le trou traversant.

10. Système de rayonnage selon une quelconque revendication précédente, dans lequel l'étagère est configurée de sorte que le composant de transmission de puissance ne puisse pas être retiré de manière non destructive de l'étagère lorsque l'étagère est montée à l'intérieur du système de rayonnage.

11. Procédé, comprenant :
le montage d'un composant de transmission de puissance sur un côté inférieur d'une étagère ;
dans lequel le composant de transmission de puissance est destiné à la transmission de puissance depuis un chemin de distribution de puissance d'un système de rayonnage vers un composant de consommation de puissance au niveau d'un bord avant d'une étagère du système de rayonnage, le composant de transmission de puissance comprenant :
un câble de puissance extensible ;
une première tête de puissance connectée à une première extrémité du câble de puissance et configurée pour mettre en prise le chemin de distribution de puissance du système de rayonnage ;
une seconde tête de puissance connectée à une seconde extrémité, opposée, du câble de puissance et configurée pour mettre en prise le composant de consommation de puissance du système de rayonnage ; et
une protection télescopique connectée à la première tête de puissance et à la seconde tête de puissance, la protection télescopique étant configurée pour au moins partiellement entourer le câble de puissance ;
l'installation de l'étagère à l'intérieur d'un système de rayonnage de sorte que la première tête de puissance du composant de transmission de puissance soit électriquement connectée à un chemin de distribution de puissance du système de rayonnage ;
le montage d'un composant de consommation de puissance au niveau d'un bord avant de l'étagère ; et
la connexion électrique du composant de consommation de puissance à la seconde tête de puissance du composant de transmission de puissance,
dans lequel l'étagère est montée sur le système de rayonnage en insérant un connecteur de l'étagère dans une fente du système de rayonnage, et en faisant tourner ultérieurement l'étagère dans une configuration horizontale, et
dans lequel la rotation de l'étagère amène la première tête de puissance du composant de transmission de puissance en connexion électrique avec le chemin de distribution de puissance du système de rayonnage.
